# DEMANDE DE BREVET EUROPEEN

(11) **EP 1 930 843 A1**
(43) Date de publication de la demande: **11.06.2008**
(21) Numéro de dépôt: 06291896.6
(22) Date de dépôt: 07.12.2006
(51) Int. Cl.: G06K 19/077, H01L 23/498, H05K 3/24

(54) **Film-support adapté a la prévention de décharge électrostatique de module électronique et procédé de fabrication de module mettant en oeuvre le film-support**

(71) Demandeur: Axalto S.A., 92190 Meudon (FR)
(72) Inventeur: Nérot, Dorothée, 92190 Meudon (FR); Fortel, Julien, 92190 Meudon (FR); Thuillard, Sardrine, 92190 Meudon (FR); Laknin, Mourad, 92190 Meudon (FR)
(74) Mandataire: Fragnaud, Aude

(57) **Abrégé**

La présente invention concerne un film-support de modules pour dispositif électronique, ledit film-support comportant un film longiligne bordé latéralement d'au moins une rive de bande métallisée et des motifs (5) de plages de contact (9) disposés sur le film, chaque motif correspondant à un module;
Il se distingue en ce qu'une seule plage de contact (17) de chaque motif (9) est reliée à au moins une rive de bande (13, 15) par au moins une piste métallique (19, 27).

L'invention concerne également un procédé de fabrication de module mettant en oeuvre ce film-support et module obtenu.

## Description

La présente invention concerne un film-support pour module électronique adapté à la prévention de décharges électrostatiques. Elle concerne également un procédé de fabrication de modules mettant en oeuvre le film-support adapté.

De tels film-supports sont utilisés notamment dans la fabrication de module à puce électronique entrant dans la composition de cartes à puce et/ou circuits imprimés.

L'invention vise de préférence des film-supports de type double-faces comportant un film diélectrique isolant fin bas coût en matériau plastique polymère PET ou PEI ou ayant un diélectrique en verre / époxy plus onéreux. L'épaisseur de ces films est environ de 75 µm. Toutefois, tout substrat flexible isolant est concerné par l'invention.

Dans la fabrication de module d'identification d'abonné pour téléphone portable de nouvelle génération et autres applications multimédia on utilise au moins 1 puce intégrant de la mémoire Flash de circuit intégré
Les puces à mémoire flash sont particulièrement sensibles aux décharges électrostatiques (ESD) qui peuvent la détériorer et rendre le module inutilisable. Ce risque est d'autant plus à considérer que ce type de puce est très onéreux.

Au cours du procédé de fabrication de modules, ces derniers sont au départ tous en court-circuit sur le film-support et sont donc reliés à la masse de la machine par contact d'une des masses du module sur la machine. Afin de pouvoir tester électriquement les modules en fin de procédé de fabrication, il faut supprimer tout court-Circuit par découpe du module ou du moins certaines interconnexions de pistes électriques de manière à rendre les plages de contacts indépendantes électriquement. Une fois décourcircuités, les modules ne sont pas nécessairement reliés à la masse de la machine, ce qui augmente le risque liés aux ESD.

L'invention a pour objectif de résoudre le problème de détérioration de puce de circuit intégré après décourt-circuitage des modules.

Un moyen selon l'invention pour éviter ce genre de problème est de conserver la masse du module en contact avec la masse de la machine sur laquelle sont produits les modules. Pour cela, il faut faire en sorte que chaque module reste relié à la masse jusqu'à la découpe de chaque module.

L'invention réside tout d'abord dans la conception d'une configuration appropriée de module permettant de relier la masse de chaque module aux rives de bande du film-support, ces dernières étant en contact avec la masse de la machine de production et/ou de test électrique.

A cet effet, l'invention a d'abord pour objet un film-support de modules pour dispositif électronique, ledit film-support comportant un film longiligne bordé latéralement d'au moins une rive de bande métallisé, et des motifs de plages de contact disposés sur le film, chaque motif correspondant à un module; Le film-support se distingue en ce qu'une seule plage de contact de chaque motif est reliée à au moins une rive de bande par au moins une piste métallique.

La plage de contact représente dans la plupart de cas une plage de masse électrique dans la mesure où les rives de bande sont en contact avec la masse des machines de production pendant le transfert des bandes.

L'invention a également pour objet un procédé de fabrication d'un module électronique, ledit procédé comportant des étapes suivantes :
- fourniture ou réalisation d'un film-support de modules comportant un film longiligne bordé latéralement d'au moins une rive de bande métallisée et des motifs de plages de contact électrique correspondant chacun à un module,
- report d'un composant électronique sur un film-support comportant des plages de contact et connexion du composant aux plages de contact,
- test du composant électronique, les bandes de rives étant au contact de la masse pendant le test,
- extraction du module du film support;

Le procédé se distingue en ce que le film-support de modules est déjà fourni avec les caractéristiques précédentes de l'invention ou en ce que le procédé comprend une étape selon laquelle le film-support subit un décourt-circuitage des plages de contact à l'exception d'une plage de contact de chaque motif restant reliée à au moins une rive de bande par au moins une piste métallique.

De cette manière, on peut réduire tout risque de détérioration de composant électronique sensible aux ESD.
D'autres caractéristiques et avantages de l'invention apparaîtront à la lecture de la description détaillée qui suit et qui est fournie en référence aux dessins annexés, dans lesquels:
- la fig. 1 illustre une vue de dessus d'une portion de film-support de module électronique selon un mode de réalisation de l'invention;
- la fig. 2 illustre l'objet de la figure 1 en vue de dessous;
- la figure 3 illustre le procédé de l'invention selon un exemple de mise en oeuvre.

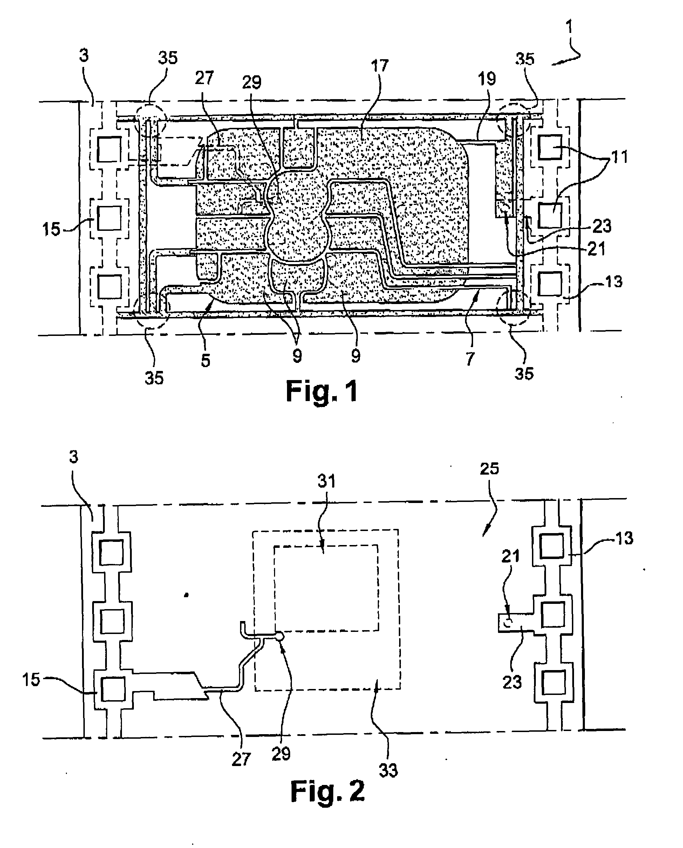

A la figure 1, on voit une portion de film-support 1 de modules électroniques selon l'invention, Le film-support se présente généralement sous forme de bobine de film ou diélectrique 3 longiligne comportant des métallisations sur une face et/ou les deux faces. Le film support est également couramment désigné par bande pour module ou substrat pour module et constitue un complexe isolant comprenant des surfaces et/ou pistes électriquement conductrices sur un isolant.

Les métallisations définissent plusieurs motifs de plages de contact disposés en chapelet sur le film et chaque motif correspond à un module 5. Dans l'exemple un motif comprend douze surfaces métalliques reliées à différentes pistes conductrices 7. Les surfaces de contact 9 sont rassemblées dans une zone sensiblement rectangle qui constitue les contact métalliques /électriques d'un module (5). Ces métallisations sont obtenues par exemple par gravure électrochimique ou par contre-collage d'une bande métallique prédécoupée sur un film diélectrique.

Le film comporte des perforations latérales 11 permettant d'entraîner le film-support sur des machines de production. Le film-support est bordé latéralement d'au moins rive de bande métallisée 13, 15 disposée autour des perforations et s'étendant en continu sur les bords du film-support. Dans l'exemple, les deux bords longitudinaux comprennent une rive de bande disposée du côté opposé aux plages de contact. Toutefois les rives de bandes pourraient être à la fois sur les deux faces et sur les deux bords longitudinaux.

Selon un mode de réalisation de l'invention, une seule plage de contact de chaque motif est reliée à au moins une rive de bande par au moins une piste métallique. Dans l'exemple, une piste métallique 19 s'étend sur le recto du film en direction du bord du film et passe de l'autre côté du film à l'aide d'un via métallisé 21. Ce via métallisé relie une autre piste conductrice 23 qui s'étend ensuite jusqu'à une rive de bande 15 disposée au verso du film.

Le cas échéant, il peut arriver que des plages de contact dites décoratives ne soient pas destinées à être connectées à un composant. Dans ce cas, elles peuvent être reliées aux rives de bandes avec la plage de masse ou être reliées à la plage de masse. Le mot "seule" ci-dessus doit être interprété dans ce cas comme englobant des plages décoratives en plus de la plage reliée à la rive de bande et destinée à être connectée au composant.

La plage de contact dans l'invention représente un contact de masse électrique 17, parmi douze plages de contact électrique dont 8 plages normalisées selon la norme ISO 7816 des cartes à puce, La plage de contact de masse 17 présente une partie sensiblement centrale du module et une partie en bordure du module.

A la figure 2, le verso du film comporte une face 25 opposée à celle portant ladite plage de contact de masse 17. Sur cette face 25, une autre piste métallique 27 s'étend jusqu'à une rive de bande 13 disposée à l'opposée de la rive précédente 15. Cette piste conductrice connecte la même plage de contact 17 représentant la masse par l'intermédiaire d'un autre via métallisé 29 à travers le film-support.

L'invention peut comprendre l'une ou l'autre connexion ci-dessus ou de préférence les deux connexions entre plage de masse et rive de bande pour plus de sureté. A cet effet, dans l'exemple, le film-support comprend donc une première piste métallique 19 s'étendant d'un côté du film jusqu'à une première rive de bande 13 et une seconde piste métallique 27 s'étendant sur la face opposée et joignant une seconde rive de bande 13,

Sur la figure 2, le film-support comprend deux emplacements 31, 33 destinés à recevoir deux puces électroniques superposées dont une mémoire de type flash.

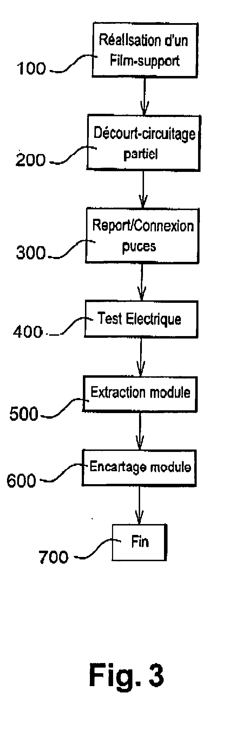

La figure 3, illustre un procédé de fabrication d'un module électronique selon un mode de mise en oeuvre de l'invention:
- Au cours d'une première étape 100, on réalise un film-support conforme à l'exemple ci-dessus mais comportant toutes les plages de contact en court-circuit. Cette mise en court-circuit est notamment utile pour réaliser des métallisations électrochimiques ou gravure,
- A l'étape 200, dite de décourt-circuitage, ce film-support défile sur des postes de travail d'une unité de fabrication de module, réalisée par exemple chez un fournisseur de film-support; les plages de contact sont décourt-circuitées chez ce fournisseur, c'est-à-dire déconnectées entre-elles et déconnectées des rives de bandes latérales, à l'exception des plages de contact 17 représentant la masse des modules qui demeurent connectées aux rives de bande; cette opération peut s'effectuer par découpe ou poinçonnage localisé d'une zone de quelques millimètres carrés notamment à quatre endroits 35 rassemblant des pistes de connexion des plages de contact électrique aux rives de bandes;
   Ce décourt-circuitage partiel peut toutefois être réalisé pendant la connexion de la puce ou après mais avec plus de risques de décharge électrostatique;
- A l'étape 300, on effectue un report d'un composant électronique accompagné le cas échéant d'une mémoire flash, sur le film-support à l'emplacement de chaque motif de plage de contact et une connexion des composants aux plages de contact, notamment par soudure filaire (dite wire-bonding); le report peut s'effectuer sur l'isolant ou sur une surface métallique;
- A l'étape 400, on effectue un test du circuit intégré et des connexions, les rives de bande étant au contact de la masse des équipements pendant le test; ce test est effectué donc en toute sécurité pour les composants à l'égard de décharges électrostatiques éventuelles;
- A l'étape 500, on effectue une extraction des modules du film support par découpe/ poinçonnage autour des douze plages de contact électrique 9 (seul 3 contacts sont indiqués sur la figure 1); l'extraction a pour effet d'enlever le court-circuit résiduel existant entre la masse et les rives de bande et de supprimer les connexions résiduelles aux pistes 7;
   Entre l'instant de la connexion de la puce de l'étape 300 et l'instant d'extraction du module, on écarte, grâce aux dispositions de l'invention, tout risque de décharge électrostatique pouvant être provoqué par exemple par le frottement sur les plateaux des machines de production ou de test et/ou pendant un stockage éventuel en bobine avec feuille intercalaire;

Le module obtenu peut constituer un dispositif électronique lui-même ou être intégré par exemple dans un support notamment par encartage à l'étape 600 ou dans un autre dispositif quelconque au cours d'étapes ultérieures pour former un dispositif électronique comprenant ce module.

## Revendications

1. Film-support de modules pour dispositif électronique, ledit film-support comportant un film longiligne bordé latéralement d'au moins une rive de bande métallisée et des motifs (5) de plages de contact (9) disposés sur le film, chaque motif correspondant à un module,
**caractérisé en ce qu'**une seule plage de contact (17) de chaque motif (9) est reliée à au moins une rive de bande (13, 15) par au moins une piste métallique (19, 27).

2. Film-support de modules selon la revendication précédente, **caractérisé en ce** ladite plage de contact (17) représente une plage de masse électrique.

3. Film-support de modules selon l'une des revendications précédentes, **caractérisé en ce que** ladite piste métallique (19) s'étend sur une face du film opposée à celle portant ladite plage, et connecte la plage de contact par l'intermédiaire d'un via métallisé (21) à travers le film.

4. Film-support de modules selon l'une des revendications précédentes, **caractérisé en ce qu'**il comprend une première piste métallique (19) s'étendant d'un côté du film jusqu'à une première bande de rive (13) et une seconde piste métallique (27) s'étendant sur la face opposée et joignant une seconde bande de rive (15).

5. Procédé de fabrication d'un module électronique, ledit procédé comportant des étapes suivantes :
- fourniture ou réalisation d'un film-support de modules (1) comportant un film longiligne bordé latéralement d'au moins une rive de bande métallisée et des motifs de plages de contact correspondant chacun à un module,
- report d'un composant électronique sur un film-support comportant des plages de contact et connexion du composant aux plages de contact,
- test du composant électronique, les bandes de rives étant au contact de la masse pendant le test,
- extraction (500) du module du film support,
**caractérisé en ce que** le film-support de modules est conforme à l'une des revendications 1 à 5,
- ou **en ce que** le procédé comprend une étape préalable. à l'extraction du module selon laquelle le film-support subit un décourt-circuitage (200) des plages de contact à l'exception d'une plage de contact (17) de chaque motif qui reste reliée à au moins une rive de bande (13, 15) par au moins une piste métallique (19, 21, 27).

6. Dispositif électronique comportant le module obtenu par la mise en oeuvre du procédé conforme à la revendication précédente.
